(19) Europäisches Patentamt
European Patent Office
Office européen des brevets

(11) **EP 2 626 672 B1**

(12) **EUROPÄISCHE PATENTSCHRIFT**

(45) Veröffentlichungstag und Bekanntmachung des Hinweises auf die Patenterteilung:
**15.03.2017 Patentblatt 2017/11**

(51) Int Cl.:
***G03F 7/20*** (2006.01)    ***G01D 5/38*** (2006.01)
***H01L 21/68*** (2006.01)

(21) Anmeldenummer: **13153226.9**

(22) Anmeldetag: **30.01.2013**

(54) **Anordnung mit mehreren Abtasteinheiten einer Positionsmesseinrichtung**

Assembly with multiple sampling units of a position measuring device

Agencement à plusieurs unités de balayage d'un dispositif de mesure de position

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **10.02.2012 DE 102012002520**

(43) Veröffentlichungstag der Anmeldung:
**14.08.2013 Patentblatt 2013/33**

(73) Patentinhaber: **Dr. Johannes Heidenhain GmbH 83301 Traunreut (DE)**

(72) Erfinder:
• **Holzapfel, Wolfgang**
  **83119 Obing (DE)**
• **Drescher, Jörg**
  **83122 Samerberg (DE)**
• **Meissner, Markus**
  **83236 Übersee (DE)**
• **Joerger, Ralph**
  **83278 Traunstein (DE)**
• **Musch, Bernhard**
  **83624 Otterfing (DE)**
• **Kälberer, Thomas**
  **86529 Schrobenhausen (DE)**

(56) Entgegenhaltungen:
**EP-A2- 1 826 615    US-A1- 2009 190 110
US-B2- 7 515 281**

EP 2 626 672 B1

**Beschreibung**

Die vorliegende Erfindung betrifft eine Anordnung mit mehreren Abtasteinheiten einer Positionsmesseinrichtung.

In Maschinen, die bei der Fertigung und Prüfung von Halbleiterbauelementen zum Einsatz kommen, besteht oftmals die Anforderung, Objekte präzise zu positionieren. So kann es etwa erforderlich sein, Wafer hochgenau unterhalb eines Werkzeugs, einer Belichtungs- oder Inspektionseinheit zu positionieren. Der Wafer liegt dabei auf einem in sechs Freiheitsgraden beweglichen Tisch, der über einen entsprechenden Antrieb bewegt wird. Als Objekt, dessen Position gegenüber einem Referenzsystem hochgenau zu erfassen ist, fungiert hier also der Tisch; als Referenzsystem dient ein demgegenüber ortsfester Referenzrahmen der Maschine. Um den Tisch über den Antrieb und eine zugehörige Steuereinheit zu positionieren, ist die Erzeugung von Positionssignalen zur räumlichen Lage des Tisches bzgl. des Referenzrahmens mittels hochgenauer Positionsmesseinrichtungen erforderlich.

Als hochgenaue Positionsmesseinrichtungen kommen in derartigen Maschinen vorrangig Interferometer oder aber gitterbasierte optische Positionsmesseinrichtungen in Betracht. Im Fall des Einsatzes gitterbasierter optischer Positionsmesseinrichtungen kann etwa vorgesehen werden, am beweglichen Tisch ein oder mehrere Abtasteinheiten anzuordnen, am Referenzrahmen ist eine geeignete Maßverkörperung angeordnet. Wenn hierbei eine Positionserfassung entlang zweier orthogonaler Hauptbewegungsachsen des Tisches erforderlich ist, ist die erforderliche Maßverkörperung als zweidimensionale Maßverkörperung in Form eines sog. Kreuzgitters ausgebildet. Wird der Tisch nunmehr entlang einer der Hauptbewegungsachsen über einen relativ großen Verfahrbereich bewegt, so ergeben sich Probleme, da dann entsprechend große zweidimensionale Maßverkörperungen erforderlich werden. Diese sind mit zunehmender Größe aber lediglich unter erheblichem Aufwand herzustellen.

Um die Fertigung sehr großer zweidimensionaler Maßverkörperungen zu vermeiden, ist bekannt, mehrere einzelne zweidimensionale Maßverkörperungen bzw. Kreuzgitterplatten zu verwenden, um auf diese Art und Weise eine Vergrößerung des Messbereichs zu ermöglichen. Die einzelnen zweidimensionalen Maßverkörperungen werden dann am Referenzrahmen benachbart zueinander entlang der jeweiligen Hauptbewegungsachse(n) platziert. Eine entsprechende Anordnung wird beispielsweise in der US 7,602,489 B2 vorgeschlagen, von der bei der Bildung des Oberbegriffes von Anspruch 1 ausgegangen wird. Dort werden insgesamt vier Kreuzgitterplatten bzw. zweidimensionale Maßverkörperungen in einer quadratischen Anordnung am Referenzrahmen befestigt, um den Messbereich abzudecken. Zur optischen Abtastung sind auf Seiten des entlang zweier orthogonaler Hauptbewegungsachsen beweglichen Objektes insgesamt vier Abtasteinheiten vorgesehen. Die Abtastgitter der vier Abtasteinheiten sind um jeweils +/- 45° gegenüber den beiden Hauptbewegungsachsen verdreht angeordnet, wobei die vier Abtasteinheiten in etwa in den Ecken eines Quadrats platziert sind. Die Ausdehnung dieses Quadrats entspricht hierbei in etwa der räumlichen Ausdehnung einer einzelnen zweidimensionalen Maßverkörperung. Im Betrieb der Maschine wird zwischen den verschiedenen Abtasteinheiten definiert umgeschaltet, um sicherzustellen, dass beim Überfahren von Stoßstellen zwischen benachbarten Maßverkörperungen keine Positionsinformation verloren geht. Um neben der Positionsbestimmung des Tisches entlang der beiden Hauptbewegungsachsen auch die Orientierung des Tisches erfassen zu können, ist es notwendig, dass stets Positionswerte von mindestens drei Abtasteinheiten mit je zwei Achsen gleichzeitig zur Verfügung stehen. Der maximale Verfahrweg entlang einer Hauptbewegungsachse entspricht in einer solchen Anordnung der Gesamt-Ausdehnung der benachbart angeordneten Kreuzgitterplatten entlang dieser Hauptbewegungsachse abzüglich des Abstands der Abtasteinheiten entlang dieser Hauptbewegungsachse.

Eine weitere Vergrößerung des Verfahrweges des beweglichen Objektes entlang zumindest einer der beiden Hauptbewegungsachsen würde bei der aus der US 7,602,489 B2 bekannten Anordnung erfordern, dass entlang dieser Hauptbewegungsachse weitere zweidimensionale Maßverkörperungen, respektive Kreuzgitterplatten, angeordnet werden oder aber diese Kreuzgitterplatten vergrößert ausgebildet werden. Beide Varianten würden jedoch einen erheblichen Mehraufwand für die Gesamtanordnung darstellen.

Aufgabe der vorliegenden Erfindung ist es daher, eine Anordnung mit mehreren Abtasteinheiten einer Positionsmesseinrichtung anzugeben, über die eine hochgenaue Positionserfassung eines Objekts möglich ist, wobei das Objekt entlang zweier orthogonaler Hauptbewegungsachsen beweglich ist. Das Objekt ist hierbei entlang einer Hauptbewegungsachse um einen Verfahrweg verschiebbar, der größer als die Ausdehnung der abgetasteten Maßverkörperung entlang dieser Hauptbewegungsachse ist.

Diese Aufgabe wird gelöst durch eine Anordnung mit den Merkmalen des Anspruches 1.

Vorteilhafte Ausführungsformen der erfindungsgemäßen Anordnung sind in den abhängigen Ansprüchen aufgeführt.

Die erfindungsgemäße Anordnung umfasst ein Objekt, das mindestens entlang zweier orthogonaler, erster und zweiter Hauptbewegungsachsen gegenüber einem Referenzsystem beweglich angeordnet ist, und eine Positionsmesseinrichtung zur Erfassung der Position des Objektes gegenüber dem Referenzsystem mit mindestens zwei, entlang der ersten Hauptbewegungsachse angeordneten, zweidimensionalen Maßverkörperungen und vier Abtasteinheiten zur optischen Abtastung der Maßverkörperungen. Die Positionsmesseinrichtung umfasst zur Positionserfassung ferner mindestens vier zusätzliche Erweiterungs-Abtasteinheiten, die entlang der ersten Hauptbewegungsachse zwischen den vier Abtasteinheiten angeordnet sind.

Vorzugsweise entspricht der maximale Abstand der äußeren Abtasteinheiten entlang der ersten Hauptbewegungsachse jeweils der Länge einer der Maßverkörperungen entlang der ersten Hauptbewegungsachse.

Mit Vorteil ist der Abstand der inneren Erweiterungs-Abtasteinheiten entlang der ersten Hauptbewegungsachse kleiner als der Abstand der äußeren Abtasteinheiten entlang der ersten Hauptbewegungsachse.

Es kann vorgesehen sein, dass der maximale Abstand der Abtasteinheiten als auch der Erweiterungs-Abtasteinheiten entlang der zweiten Hauptbewegungsachse der Länge der Maßverkörperungen entlang der zweiten Hauptbewegungsachse entspricht.

In einer vorteilhaften Ausführungsform resultiert entlang der ersten Hauptbewegungsachse ein maximaler Verfahrweg

$$V = 2 \cdot DM_y - DA_{y2}.$$

mit

V:= maximaler Verfahrweg entlang der ersten Hauptbewegungsachse, $DM_y$:= Länge der Maßverkörperungen entlang der ersten Hauptbewegungsachse,
$DA_{y2}$:= Abstand der Erweiterungs-Abtasteinheiten entlang der ersten Hauptbewegungsachse.

Entlang dieses Verfahrwegs ist eine durchgängige Positionserfassung über die Abtasteinheiten und die Erweiterungs-Abtasteinheiten möglich.

Es ist in einer Ausführungsform der erfindungsgemäßen Anordnung möglich, die vier Abtasteinheiten und die vier Erweiterungs-Abtasteinheiten auf einer Seite des Objekts anzuordnen.

In einer bevorzugten Ausführungsform umfassen die Abtasteinheiten als auch die Erweiterungs-Abtasteinheiten u.a. jeweils ein eindimensionales Abtastgitter, wobei die Abtasteinheiten als auch die Erweiterungs-Abtasteinheiten derart angeordnet sind, dass die Gitterstriche der jeweils zugehörigen Abtastgitter um +45° oder um -45° verdreht gegenüber der ersten Hauptbewegungsachse orientiert sind.

Mit Vorteil sind zur Positionserfassung wahlweise einzelne Abtasteinheiten und/oder Erweiterungs-Abtasteinheiten aktivierbar ausgebildet.

Anstelle die Ausdehnung und/oder Anzahl der zweidimensionalen Maßverkörperungen zur Messbereichserweiterung zu vergrößern, ist im Rahmen der vorliegenden Erfindung demnach vorgesehen, die Anzahl der genutzten Abtasteinheiten durch mindestens vier zusätzliche Erweiterungs-Abtasteinheiten zu vergrößern und über eine geeignet gewählte Anordnung der Abtasteinheiten und der Erweiterungs-Abtasteinheiten eine Vergrößerung des Messbereichs zu bewerkstelligen. Dies stellt eine deutlich weniger aufwendige Lösung dar, als wenn im Vergleich hierzu etwa weitere bzw. größere zweidimensionale Maßverkörperungen eingesetzt würden.

Weitere Einzelheiten und Vorteile der vorliegenden Erfindung seien anhand der nachfolgenden Beschreibung von Ausführungsbeispielen in Verbindung mit den Figuren erläutert.

Es zeigt

| | |
|---|---|
| Figur 1a | eine schematisierte Darstellung einer Ausführungsform der erfindungsgemäßen Anordnung; |
| Figur 1b | eine schematisierte Teil-Ansicht einer zweidimensionalen Maßverkörperung und zweier Abtasteinheiten der Ausführungsform der erfindungsgemäßen Anordnung; |
| Figur 2 | eine schematisierte dreidimensionale Ansicht der Ausführungsform der erfindungsgemäßen Anordnung; |
| Figur 3a - 3d | jeweils einen Abschnitt des Verfahrbereichs während des Betriebs der Ausführungsform der erfindungsgemäßen Anordnung; |
| Figur 4 | eine schematisierte Darstellung einer Anordnung mit mehreren Abtasteinheiten einer Positionsmesseinrichtung. |

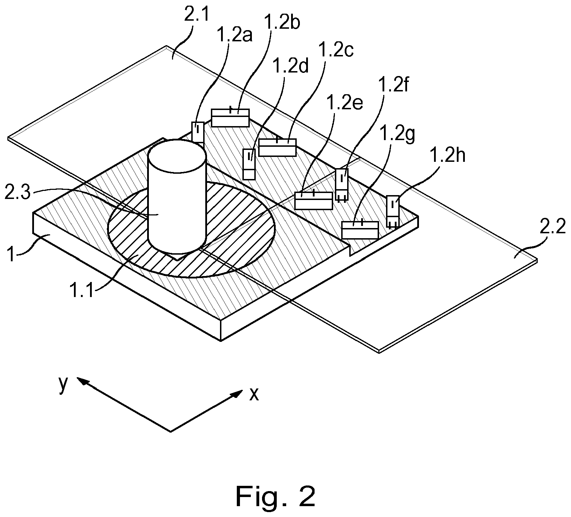

Anhand der Figuren 1a, 1b und 2 sei nachfolgend eine Ausführungsform der erfindungsgemäßen Anordnung erläutert; die Figuren 3a - 3d dienen zur Erläuterung eines Bearbeitungsprozesses mit Hilfe dieser Ausführungsform. Hierbei sind in diesen Figuren jeweils nur die für die erfindungsgemäße Anordnung maßgeblichen Komponenten dargestellt, insbesondere jedoch nicht die Details einer entsprechenden Maschine, in der eine solche Anordnung zum Einsatz kommen kann. Beispielsweise kann es sich hierbei um eine Maschine handeln, die zur Halbleiter-Fertigung oder zur Halbleiter-Inspektion eingesetzt wird.

Die erfindungsgemäße Anordnung dient zur Positionserfassung eines beweglichen Objekts 1 gegenüber einem Referenzsystem. Beim Objekt 1 kann es sich etwa um einen Tisch in der Maschine handeln, der entlang der beiden orthogonalen Hauptbewegungsachsen x, y beweglich angeordnet ist; auf dem Tisch ist ein Wafer 1.1 platziert, welcher bearbeitet und/oder inspiziert werden soll. Die in den Figuren mit dem Bezugszeichen y versehene Hauptbewegungsachse sei nachfolgend als erste Hauptbewegungsachse bezeichnet, mit dem Bezugszeichen x wird eine zweite Hauptbewegungsachse bezeichnet, die senkrecht zur ersten Hauptbewegungsachse y orientiert ist. Über die beiden Hauptbewegungsachsen y, x wird in der Maschine eine Bewegungsebene aufgespannt, in der der Tisch bzw. das Objekt 1 während der Bearbeitung oder Inspektion definiert positioniert werden muss. Üblicherweise ist das Objekt 1 desweiteren noch entlang einer zu den beiden Hauptbewegungsachsen x, y senkrecht orientierten dritten Achse beweglich, was im Fall der vorliegenden Erfindung aber nicht weiter von Bedeutung ist.

Gegenüber dem beweglichen Objekt 1 ist in einem festen Referenzsystem, beispielsweise ausgebildet als Referenzrahmen der Maschine, ein Bearbeitungswerkzeug 2.3 angeordnet. Mit dem Bearbeitungswerkzeug 2.3 sind im gegenüber dem Objekt 1 stationären Referenzsystem zwei identische, zweidimensionale Maßverkörperungen 2.1, 2.2 mechanisch gekoppelt angeordnet. Im dargestellten Ausführungsbeispiel sind die beiden zweidimensionalen Maßverkörperungen 2.1, 2.2 benachbart entlang der ersten Hauptbewegungsachse y angeordnet. Die jeweilige Länge bzw. Ausdehnung der Maßverkörperungen 2.1, 2.2 entlang der ersten Hauptbewegungsachse y sei nachfolgend mit $DM_y$ bezeichnet, die Länge entlang der zweiten Hauptbewegungsachse x mit $DM_x$.

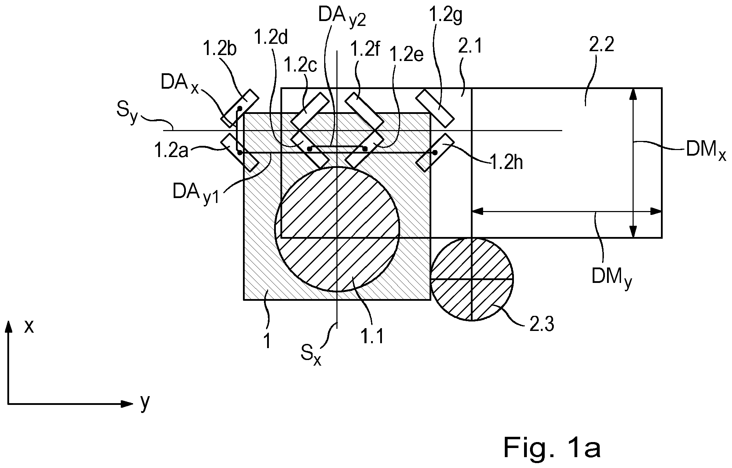

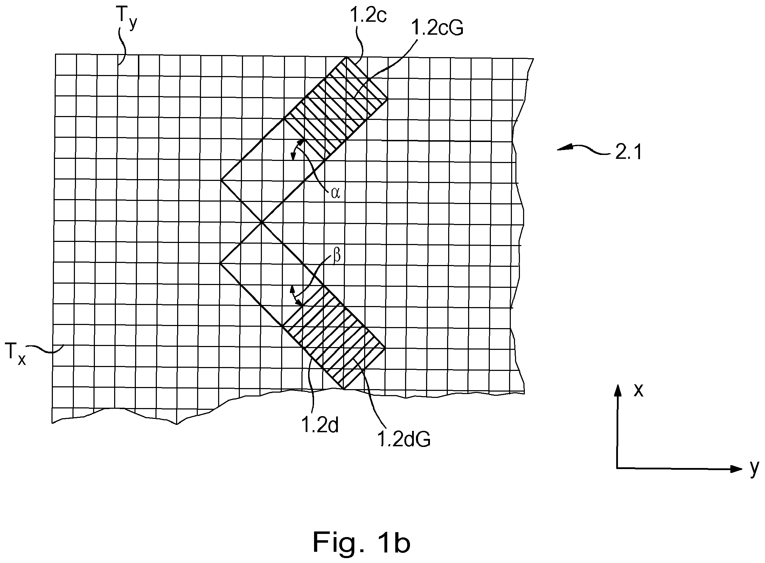

Die beiden zweidimensionalen Maßverkörperungen 2.1, 2.2 sind als Kreuzgitterplatten ausgebildet und weisen zwei senkrecht zueinander orientierte Gitterteilungen in Form von Auflicht-Beugungsgittern auf. Eine erste Gitterteilung umfasst periodisch in y-Richtung angeordnete Teilungsmarkierungen $T_y$, eine zweite Gitterteilung, die der ersten Gitterteilung überlagert ist, umfasst periodisch in x-Richtung angeordnete Teilungsmarkierungen $T_x$, wie dies in einer vergrößerten schematischen Darstellung der zweidimensionalen Maßverkörperung 2.1 in Figur 1 b angedeutet ist. In einem möglichen Ausführungsbeispiel besitzen die beiden Gitterteilungen Teilungsperioden im Bereich von 2,048 μm.

Auf Seiten des beweglichen Objektes 1 sind desweiteren insgesamt acht Abtasteinheiten 1.2a -1.2h angeordnet, die zur optischen Abtastung der zweidimensionalen Maßverkörperungen 2.1, 2.2 und der Erzeugung von Positionssignalen dienen. Neben vier äußeren Abtasteinheiten 1.2a, 1.2b und 1.2g, 1.2h sind hierbei erfindungsgemäß mindestens vier innere, zusätzliche Erweiterungs-Abtasteinheiten 1.2c, 1.2d, 1.2e, 1.2f vorgesehen. Über die optische Abtastung der Maßverkörperungen 2.1, 2.2 werden im Betrieb der Maschine Positionssignale bzgl. der Bewegung des Objektes 1 bzw. des Tisches mit dem Wafer 1.1 gegenüber dem Referenzsystem mit dem Bearbeitungswerkzeug 2.3 erzeugt

und einer Maschinensteuerung zur Weiterverarbeitung zur Verfügung gestellt. Im Hinblick auf weitere Details einer geeigneten optischen Abtastung sei z.B. auf die EP 1 762 828 A2 der Anmelderin verwiesen.

Üblicherweise umfassen die Abtasteinheiten 1.2a, 1.2b, 1.2g, 1.2h als auch die Erweiterungs-Abtasteinheiten 1.2c, 1.2d, 1.2e, 1.2f zur Erzeugung der Positionssignale verschiedene Optikkomponenten, darunter auch ein eindimensionales Abtastgitter 1.2dG, 1.2cG, wie dies in Figur 1 b schematisiert in Verbindung mit den beiden Erweiterungs-Abtasteinheiten 1.2c, 1.2d angedeutet ist. Die eindimensionalen Abtastgitter 1.2dG, 1.2cG bestehen jeweils aus periodisch entlang einer Richtung angeordneten Teilungsmarkierungen. Hierbei sind im vorliegenden Ausführungsbeispiel die Teilungsmarkierungen der Abtastgitter 1.2dG, 1.2cG um den Winkel α = + 45° bzw. β = - 45° verdreht gegenüber der ersten Hauptbewegungsachse y angeordnet. Über derart ausgebildete Abtasteinheiten bzw. Erweiterungs-Abtasteinheiten lassen sich bei einem Verfahren des Objekts 1 entlang der ersten Hauptbewegungsachse y hochauflösende inkrementale Positionssignale bzgl. der erfolgenden Relativbewegung in dieser Richtung erzeugen; gleichzeitig werden aufgrund der verdreht angeordneten Abtastgitter 1.2dG, 1.2cG weitere inkrementale Abtastsignale erzeugt, die für andere Zwecke nutzbar sind.

Sowohl die vier äußeren Abtasteinheiten 1.2a, 1.2b, 1.2g, 1.2h als auch die vier Erweiterungs-Abtasteinheiten 1.2c, 1.2d, 1.2e, 1.2f sind - wie aus Figur 1 a ersichtlich - spiegelsymmetrisch zu einer ersten Symmetrieachse $S_y$ angeordnet, die parallel zur ersten Hauptbewegungsachse y orientiert ist. Ferner sind die vier äußeren Abtasteinheiten 1.2a, 1.2b, 1.2g, 1.2h als auch die vier Erweiterungs-Abtasteinheiten 1.2c, 1.2d, 1.2e, 1.2f auch spiegelsymmetrisch zu einer zweiten Symmetrieachse $S_x$ angeordnet, die parallel zur zweiten Hauptbewegungsachse x orientiert ist

Zwei Abtasteinheiten 1.2a, 1.2b und zwei Erweiterungs-Abtasteinheiten 1.2c, 1.2d sind hierbei auf einer Seite (links) der zweiten Symmetrieachse $S_x$ angeordnet sind, die parallel zur zweiten Hauptbewegungsachse x orientiert ist. Diese Abtasteinheiten 1,2a, 1.2b und Erweiterungs-Abtasteinheiten 1.2c, 1.2d sind derart angeordnet, dass die Gitterstriche der jeweils zugehörigen Abtastgitter um +45° verdreht gegenüber der ersten Hauptbewegungsachse y orientiert sind. Die zwei anderen Abtasteinheiten 1.2g, 1.2h und Erweiterungs-Abtasteinheiten 1.2e, 1.2f sind auf der anderen Seite (rechts) dieser zweiten Symmetrieachse $S_x$. Diese Abtasteinheiten 1,2g, 1.2h und Erweiterungs-Abtasteinheiten 1.ec, 1.2f sind derart angeordnet, dass die Gitterstriche der jeweils zugehörigen Abtastgitter um -45° verdreht gegenüber der ersten Hauptbewegungsachse y orientiert sind.

Sowohl die vier äußeren Abtasteinheiten 1.2a, 1.2b, 1.2g, 1.2h als auch die vier inneren Erweiterungs-Abtasteinheiten 1.2c, 1.2d, 1.2e, 1.2f sind in dieser Ausführungsform der erfindungsgemäßen Anordnung i.w. auf einer Seite des Objekts 1 bzw. Tisches angeordnet, nämlich auf der Seite, die in Figur 1 a nach oben zeigt. Eine derartige Variante ermöglicht eine kompakte Ausbildung der Gesamt-Anordnung, insbesondere eine kompakte Ausbildung des Tisches entlang der zweiten Hauptbewegungsrichtung x. Ferner sind im Gegensatz zum Stand der Technik für den erforderlichen Verfahrweg entlang der ersten Hauptbewegungsachse y lediglich zwei zweidimensionale Maßverkörperungen 2.1, 2.2 erforderlich.

Desweiteren ist vorgesehen, dass die entlang der ersten Hauptbewegungsrichtung y äußeren Abtasteinheiten 1.2a, 1.2b und 1.2g, 1.2h einen Maximal-Abstand zueinander aufweisen, der der Länge $DM_y$ einer Maßverkörperung 2.1, 2.2 entspricht. Im dargestellten Ausführungsbeispiel ist genau dieser Maximal-Abstand gewählt, d.h. der Abstand $DA_{y1}$ der äußeren Abtasteinheiten 1.2a, 1.2b und 1.2g, 1.2h wurde mit $DA_{y1} = DM_y$ gewählt; grundsätzlich ist es aber auch möglich, hier einen kleineren Abstand $DA_{y1}$ zwischen den äußeren Abtasteinheiten 1.2a, 1.2b und 1.2g, 1.2h zu wählen.

Zusätzlich bzw. zwischen den vier äußeren Abtasteinheiten 1.2a, 1.2b und 1.2g, 1.2h sind in der erfindungsgemäßen Anordnung nunmehr noch mindestens vier zusätzliche Erweiterungs-Abtasteinheiten 1.2c, 1.2d, 1.2e, 1.2f vorgesehen, die entlang der ersten Hauptbewegungsachse y zwischen den vier äußeren Abtasteinheiten 1.2a, 1.2b und 1.2g, 1.2h angeordnet sind. Die vier innenliegenden Erweiterungs-Abtasteinheiten 1.2c, 1.2d, 1.2e, 1.2f weisen entlang der ersten Hauptbewegungsachse y einen Abstand $DA_{y2}$ auf, der kleiner als der oben erwähnte Abstand $DA_{y1}$ der äußeren Abtasteinheiten 1.2a, 1.2b, 1.2g, 1.2h gewählt ist.

Entlang der zweiten Hauptbewegungsachse x weisen die beidseitig der Symmetrieachse S angeordneten Abtasteinheiten 1.2a, 1.2b, 1.2g, 1.2h bzw. Erweiterungs-Abtasteinheiten 1.2c, 1.2d, 1.2e, 1.2f allesamt den gleichen Abstand $DA_x$ auf. Maximal darf dieser Abstand $DA_x$ der Länge $DM_x$ der Maßverkörperungen 2.1, 2.2 entlang der zweiten Hauptbewegungsachse x entsprechen. Im Ausführungsbeispiel ist - wie aus Figur 1a ersichtlich - der Abstand $DA_x$ jedoch deutlich kleiner als die Länge $DM_x$ der Maßverkörperungen 2.1, 2.2 entlang dieser Richtung gewählt worden.

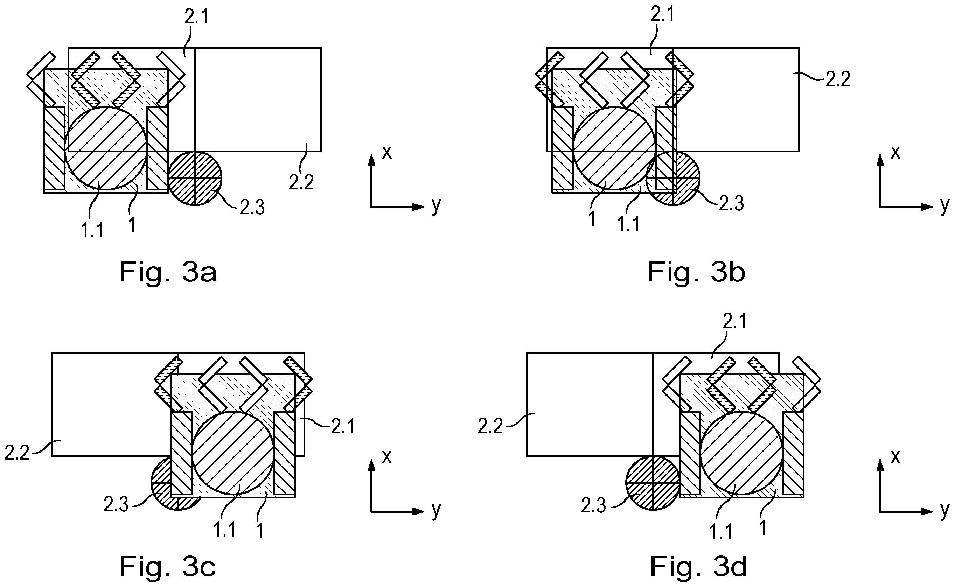

Aufgrund einer derartigen Ausbildung der erfindungsgemäßen Anordnung ist es nunmehr möglich, den Verfahrweg des Objektes 1 entlang der ersten Hauptbewegungsachse y zu vergrößern, innerhalb dessen eine hochgenaue Positionserfassung möglich ist. So wäre etwa bei einer Lösung gemäß dem Stand der Technik mit lediglich vier äußeren Abtasteinheiten 1.2a, 1.2b, 1.2g, 1.2h eine Positionserfassung entlang der y-Achse maximal über einen Verfahrweg $V = 2 \cdot DM_y - DA_{y1}$ möglich gewesen. Über die zusätzlich vorgesehenen vier Erweiterungs-Abtasteinheiten 1.2c, 1.2d, 1.2e, 1.2f lässt sich der mögliche Verfahrweg des Objektes 1 nunmehr ohne zusätzliche oder größere Maßverkörperungen 2.1, 2.2 auf den Verfahrweg $V = 2 \cdot DM_y - DA_{y2}$ erweitern, da wie aus Figur 1a ersichtlich $DA_{y1} > DA_{y2}$ gilt. Diese Verfahrweg-Erweiterung wird nachfolgend anhand der Figuren 3a - 3d veranschaulicht.

Die Figuren 3a - 3d zeigen jeweils verschiedene Stadien eines Bearbeitungsprozesses in einer Maschine zur Halbleiterfertigung, in der die Ausführungsform der erfindungsgemäßen Anordnung zur Positionserfassung eines Tisches eingesetzt wird. In den einzelnen Stadien dieses Prozesses werden jeweils nur vier der insgesamt acht vorhandenen Abtasteinheiten bzw. Erweiterungs-Abtasteinheiten zur Positionserfassung verwendet; innerhalb der erfindungsgemäßen Anordnung sind demzufolge einzelne Abtasteinheiten bzw. Erweiterungs-Abtasteinheiten selektiv für die Positionserfassung von einer - nicht dargestellten - Steuereinheit aktivierbar. Die in den verschiedenen Prozess-Stadien jeweils aktivierten Abtasteinheiten bzw. Erweiterungs-Abtasteinheiten sind in den Figuren 3a - 3d strichliniert markiert.

Figur 3a zeigt eine Beschleunigungsphase dieses Bearbeitungsprozesses, innerhalb der das Objekt 1 bzw. der Tisch entlang der ersten Hauptbewegungsachse y möglichst schnell von links nach rechts in die Nähe derjenigen Position verfahren wird, in der eine Bearbeitung des Wafers 1.1 mit dem Bearbeitungswerkzeug 2.3 stattfinden soll. In dieser Phase erfolgt die Positionserfassung über die vier innen angeordneten Erweiterungs-Abtasteinheiten, die in dieser Phase durchgängig die in der Figur 3a links angeordnete Maßverkörperung 2.1 abtasten.

In Figur 3b ist nach dem Erreichen der gewünschten Objekt-Position in der Nähe der Bearbeitungsposition sodann der Beginn einer Messphase dargestellt. In der Messphase wird bei gleichzeitiger Bearbeitung des Wafers 1.1 die Position des Objekts 1 mit hoher Genauigkeit über die vier außenliegenden Abtasteinheiten erfasst. Die vier außenliegenden Abtasteinheiten sind in dieser Phase aktiviert und tasten die beiden Maßverkörperungen 2.1, 2.2 zur Erzeugung von Positionssignalen ab. Es ist aufgrund des gewählten Abstands der äußeren Abtasteinheiten hierbei sichergestellt, dass auch im Fall des Überfahrens der Stoßstelle zwischen den beiden Maßverkörperungen 2.1, 2.2 stets ein Positionssignal der übergeordneten Steuereinheit zur Verfügung steht. In dieser Messphase können die vier inneren Erweiterungs-Abtasteinheiten zu anderen Zwecken genutzt werden, beispielsweise zur Durchführung von Kalibrierungsmessungen oder dgl..

In Figur 3c ist das Ende der Messphase des Bearbeitungsprozesses dargestellt. Das Objekt 1 ist hierbei noch etwas weiter entlang der ersten Hauptbewegungsachse y nach rechts verfahren worden. Auch in dieser Phase erfolgt die hochgenaue Positionserfassung über die vier äußeren Abtasteinheiten, die sich nach wie vor oberhalb der beiden Maßverkörperungen 2.1, 2.2 befinden. Über die vier Erweiterungs-Abtasteinheiten können nach wie vor Positionsmessungen zu anderen Zwecken erfolgen.

Figur 3d zeigt schließlich eine finale Abbremsphase des Bearbeitungsprozesses, in dem das Objekt 1 noch weiter nach rechts verfahren wird. In dieser Phase wird die Position des Objekts 1 über die jetzt wieder aktivierten vier Erweiterungs-Abtasteinheiten erfasst.

Wie aus dieser Beschreibung eines Bearbeitungsprozesses und den zugehörigen Figuren ersichtlich ist, kann über die erfindungsgemäße Anordnung eine Positionserfassung entlang des Verfahrwegs V über einen Bereich erfolgen, der größer als die Länge $DM_y$ der beiden Maßverkörperungen 2.1, 2.2 entlang dieser Hauptbewegungsachse y ist. Wie oben erläutert, resultiert ein erfindungsgemäß vergrößerter Verfahrweg

$$V = 2 \cdot DM_y - DA_{y2}.$$

Neben dem anhand der Figuren 3a - 3d erläuterten Aktivierungsprocedere für die einzelnen Abtasteinheiten bzw. Erweiterungs-Abtasteinheiten sind in Verbindung mit der erläuterten Ausführungsform der erfindungsgemäßen Anordnung auch alternative Umschalt-Varianten während eines Bearbeitungsprozesses realisierbar. So könnte etwa in einer Beschleunigungsphase gemäß Figur 3a zur Positionsbestimmung auch ein Paar der Erweiterungs-Abtasteinheiten zusammen mit einem Paar der Abtasteinheiten genutzt werden. Noch während der Beschleunigung könnten sodann die Erweiterungs-Abtasteinheiten vollständig zur Positionserfassung hinzugeschaltet werden. Während des Messbetriebs würde wiederum mit den äußeren Abtasteinheiten die Position erfasst und während des nachfolgenden Abbremsens die Erweiterungs-Abtasteinheiten hinzugeschaltet. Am Ende der Abbremsphase könnte schließlich die Positionserfassung wieder mit einem Paar der Erweiterungs-Abtasteinheiten und mit einem Paar der Abtasteinheiten erfolgen. Die Nutzung aller jeweils maximal möglichen Abtasteinheiten gemäß dem skizzierten alternativen Vorgehen erweist sich etwa als vorteilhaft, um darüber eine Reduzierung des Positionsrauschens in den erzeugten Positionssignalen zu erreichen. Es sind demzufolge unterschiedliche Varianten zur Nutzung der erfindungsgemäßen Anordnung und insbesondere zur Aktivierung und Nutzung der verschiedenen Abtasteinheiten bzw. Erweiterungs-Abtasteinheiten realisierbar.

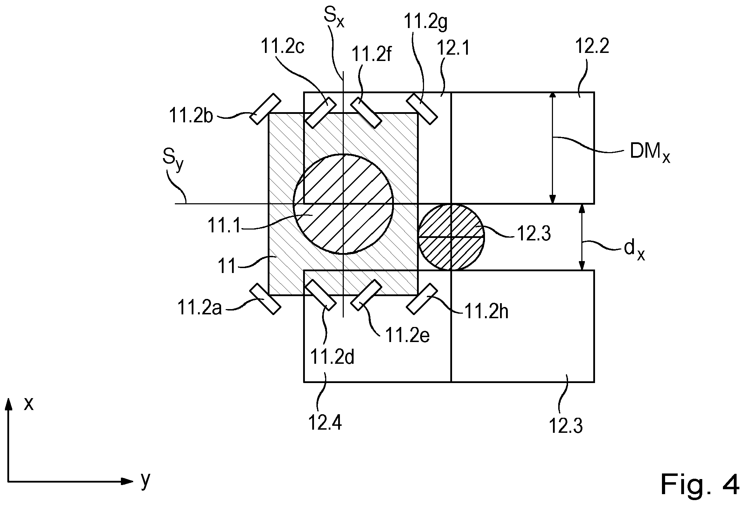

Eine weitere Anordnung mit mehreren Abtasteinheiten einer Positionsmesseinrichtung sei abschließend anhand der Figur 4 erläutert.

Nachfolgend werden i.w. nur die maßgeblichen Unterschiede zur erläuterten Ausführungsform der erfindungsgemäßen Anordnung erläutert.

Der maßgebliche Unterschied zur erläuterten Ausführungsform besteht hierbei darin, dass nunmehr vier zweidimensionale Maßverkörperungen 12.1 - 12.4 in quadratischer Anordnung vorgesehen werden; mittig zu den vier Maßverkörperungen 12.1 - 12.4 ist das Bearbeitungswerkzeug 12.3 platziert. Zusätzlich zu den beiden Maßverkörperungen 12.1, 12.2, die entlang der ersten Hauptbewegungsachse y angeordnet sind, sind zwei weitere Maßverkörperungen 12.3, 12.4 vorgesehen, die entlang der zweiten Hauptbewegungsachse x benachbart zu den beiden erstgenannten Maßverkörperungen 12.1, 12.2 angeordnet werden. Alle vier verwendeten Maßverkörperungen 12.1 - 12.4 sind hinsichtlich ihrer Abmessungen und den darauf angeordneten Auflicht-Beugungsgittern identisch ausgebildet.

Als weiterer Unterschied zum erläuterten Ausführungsbeispiel ist als Konsequenz aus der Verwendung von nunmehr vier zweidimensionalen Maßverkörperungen eine etwas modifizierte Anordnung der vier äußeren Abtasteinheiten 11.2a, 11.2b, 11.2g, 11.2h und der vier inneren Erweiterungs-Abtasteinheiten 11.2c, 11.2d, 11.2e, 11.2f vorgesehen. Während die Lage der zweiten Symmetrieachse $S_x$ identisch zum vorherigen Beispiel gewählt ist, liegt nunmehr die erste Symmetrieachse $S_y$ exakt in der Mitte des Objekts 11. Dies bedeutet, dass die zwei Abtasteinheiten 11.2b, 11.2g und die zwei Erweiterungs-Abtasteinheiten 11.2c, 11.2f auf einer Seite des Objekts 11 angeordnet sind und die zwei Abtasteinheiten 11.2a, 11.2h und die zwei Erweiterungs-Abtasteinheiten 11.2d, 11.2e auf der anderen, entgegengesetzten Seite des Objekts 11 bzw. Tisches. Die oben diskutierten Abstandsbedingungen gelten somit unverändert für die Abstände der Abtasteinheiten 11.2a, 11.2b, 11.2g, 11.2h und der Erweiterungs-Abtasteinheiten 11.2c, 11.2d, 11.2e, 11.2f entlang der ersten Hauptbewegungsachse y. Für die Abstände entlang der zweiten Hauptbewegungsachse x resultieren nunmehr jedoch andere Bedingungen. So entspricht der minimale Abstand der Abtasteinheiten 11.2a, 11.2b, 11.2g, 11.2h als auch der Erweiterungs-Abtasteinheiten 11.2c, 11.2d, 11.2e, 11.2f entlang der zweiten Hauptbewegungsachse x der Summe aus dem Abstand $d_x$ der zweidimensionalen Maßverkörperungen 12.1 - 12.4 entlang der zweiten Hauptbewegungsachse x und der Länge $DM_x$ der Maßverkörperungen 12.1 - 12.4 entlang der zweiten Hauptbewegungsachse x. Kleiner als ein derartiger Minimalabstand kann der Abstand der Abtasteinheiten 11.2a, 11.2b, 11.2g, 11.2h und der Erweiterungs-Abtasteinheiten 11.2c, 11.2d, 11.2e, 11.2f entlang der zweiten Bewegungsachse x nicht gewählt werden, wenn sichergestellt sein soll, dass in jeder Objektposition relativ zu den Maßverkörperungen 12.1 - 12.4 ein Positionssignal erzeugbar ist.

Insgesamt resultieren bei einer derartigen Variante größere Abmessungen des Objektes 11 bzw. des Tisches entlang der zweiten Hauptbewegungsachse x. Wenn dies für die jeweilige Anwendung akzeptabel ist, ergibt sich als Vorteil, dass der Tisch dann symmetrisch bauend ausgebildet werden kann. Dies kann sich vorteilhaft auf die Dynamik des Gesamtsystems auswirken.

Neben dem erläuterten Ausführungsbeispiel der erfindungsgemäßen Positionsmesseinrichtungen bzw. der erfindungsgemäßen Anordnung gibt es selbstverständlich im Rahmen der vorliegenden Erfindung noch weitere Ausgestaltungsmöglichkeiten. So wäre denkbar, beim erläuterten Ausführungsbeispiel entlang der ersten Hauptbewegungsachse y einen definierten Abstand vorzusehen, um darüber ggf. nochmals den verfügbaren Verfahrweg zu vergrößern. Desweiteren ist es natürlich möglich, ggf. auch mehr als vier Erweiterungs-Abtasteinheiten einzusetzen etc..

Insgesamt resultieren bei einer derartigen Variante der erfindungsgemäßen Anordnung größere Abmessungen des Objektes 11 bzw. des Tisches entlang der zweiten Hauptbewegungsachse x. Wenn dies für die jeweilige Anwendung akzeptabel ist, ergibt sich als Vorteil dieser Ausführungsform, dass der Tisch dann symmetrisch bauend ausgebildet werden kann. Dies kann sich vorteilhaft auf die Dynamik des Gesamtsystems auswirken. Neben den erläuterten Ausführungsbeispielen der erfindungsgemäßen Positionsmesseinrichtungen bzw. der erfindungsgemäßen Anordnung gibt es selbstverständlich im Rahmen der vorliegenden Erfindung noch weitere Ausgestaltungsmöglichkeiten. So kann die zweite erläuterte Ausführungsform dahingehend abgewandelt werden, dass entlang der zweiten Hauptbewegungsachse x kein Abstand zwischen den zweidimensionalen Maßverkörperungen vorgesehen wird. In den zweidimensionalen Maßverkörperungen wäre dann eine geeignete Aussparung für das Werkzeug anzubringen. Ferner wäre denkbar, bei den erläuterten Ausführungsbeispielen entlang der ersten Hauptbewegungsachse y einen definierten Abstand vorzusehen, um darüber ggf. nochmals den verfügbaren Verfahrweg zu vergrößern. Desweiteren ist es natürlich möglich, ggf. auch mehr als vier Erweiterungs-Abtasteinheiten einzusetzen etc..

**Patentansprüche**

1.  Anordnung mit

    - einem Objekt (1), das mindestens entlang zweier orthogonaler, erster und zweiter Hauptbewegungsachsen (y, x) gegenüber einem Referenzsystem beweglich angeordnet ist, und
    - einer Positionsmesseinrichtung zur Erfassung der Position des Objektes (1; 11) gegenüber dem Referenzsystem mit mindestens zwei, entlang der ersten Hauptbewegungsachse (y) angeordneten, zweidimensionalen Maßverkörperungen (2.1, 2.2) und vier Abtasteinheiten (1.2a, 1.2b, 1.2g, 1.2h) zur optischen Abtastung der Maßverkörperungen (2.1, 2.2),

    **dadurch gekennzeichnet,**

    - **dass** die Positionsmesseinrichtung zur Positionserfassung mindestens vier zusätzliche Erweiterungs-Abtasteinheiten (1.2c - 1.2f) umfasst, die entlang der ersten Hauptbewegungsachse (y) zwischen den vier Abtasteinheiten (1.2a, 1.2b, 1.2g, 1.2h) angeordnet sind und
    - **dass** die vier Abtasteinheiten (1.2a, 1.2b, 1.2g, 1.2h) und die vier Erweiterungs-Abtasteinheiten (1.2c - 1.2f) auf einer Seite des Objekts (1) angeordnet sind.

2.  Anordnung nach Anspruch 1, **dadurch gekennzeichnet, dass** der maximale Abstand ($DA_{y1}$) der äußeren Abtasteinheiten (1.2a, 1.2b, 1.2g, 1.2h) entlang der ersten Hauptbewegungsachse (y) jeweils der Länge ($DM_y$) einer der Maßverkörperungen (2.1, 2.2) entlang der ersten Hauptbewegungsachse (y) entspricht.

3.  Anordnung nach Anspruch 2, **dadurch gekennzeichnet, dass** der Abstand ($DA_{y2}$) der inneren Erweiterungs-Abtasteinheiten (1.2c - 1.2f) entlang der ersten Hauptbewegungsachse (y) kleiner als der Abstand ($DA_{y1}$) der äußeren Abtasteinheiten (1.2a, 1.2b, 1.2g, 1.2h) entlang der ersten Hauptbewegungsachse (y) ist.

4.  Anordnung nach Anspruch 1, **dadurch gekennzeichnet, dass** der maximale Abstand ($DA_x$) der Abtasteinheiten (1.2a, 1.2b, 1.2g, 1.2h) als auch der Erweiterungs-Abtasteinheiten (1.2c - 1.2f) entlang der zweiten Hauptbewegungsachse (x) der Länge ($DM_x$) der Maßverkörperungen (2.1, 2.2) entlang der zweiten Hauptbewegungsachse (x) entspricht.

5.  Anordnung nach Anspruch 1, **dadurch gekennzeichnet, dass** entlang der ersten Hauptbewegungsachse (y) ein maximaler Verfahrweg

    $$V = 2 \cdot DM_y - DA_{y2}.$$

    mit

    V := maximaler Verfahrweg entlang der ersten Hauptbewegungsachse,
    $DM_y$ := Länge der Maßverkörperungen entlang der ersten Hauptbewegungsachse,
    $DA_{y2}$ := Abstand der Erweiterungs-Abtasteinheiten entlang der ersten Hauptbewegungsachse,

    resultiert, wobei entlang dieses Verfahrwegs (V) eine durchgängige Positionserfassung über die Abtasteinheiten (1.2a, 1.2b, 1.2g, 1.2h) und die Erweiterungs-Abtasteinheiten (1.2c - 1.2f) möglich ist.

6.  Anordnung nach mindestens einem der vorhergehenden Ansprüche, **dadurch gekennzeichnet, dass** die Abtasteinheiten (1.2a, 1.2b, 1.2g, 1.2h) als auch die Erweiterungs-Abtasteinheiten (1.2c - 1.2f) jeweils ein eindimensionales Abtastgitter (1.2cG, 1.2dG) umfassen und die Abtasteinheiten (1.2a, 1.2b, 1.2g, 1.2h) als auch die Erweiterungs-Abtasteinheiten (1.2c - 1.2f) derart angeordnet sind, dass die Gitterstriche der jeweils zugehörigen Abtastgitter (1.2cG, 1.2dG) um +45° oder um -45° verdreht gegenüber der ersten Hauptbewegungsachse (y) orientiert sind.

7. Anordnung nach mindestens einem der vorhergehenden Ansprüche, **dadurch gekennzeichnet, dass** zur Positionserfassung wahlweise einzelne Abtasteinheiten (1.2a, 1.2b, 1.2g, 1.2h; 11.2a; 11.2b, 11.2g, 11.2h) und/oder Erweiterungs-Abtasteinheiten (1.2c - 1.2f; 11.2c - 11.2f) aktivierbar ausgebildet sind.

**Claims**

1. Assembly having

   - an object (1) which is arranged such that it can be moved with respect to a reference system at least along two orthogonal, first and second main movement axes (y, x), and
   - a position measuring device for detecting the position of the object (1; 11) with respect to the reference system and having at least two two-dimensional scales (2.1, 2.2) arranged along the first main movement axis (y) and four scanning units (1.2a, 1.2b, 1.2g, 1.2h) for the optical scanning of the scales (2.1, 2.2),

   **characterized**

   - **in that** the position measuring device for position detection comprises at least four additional supplementary scanning units (1.2c - 1.2f), which are arranged along the first main movement axis (y), between the four scanning units (1.2a, 1.2b, 1.2g, 1.2h), and
   - **in that** the four scanning units (1.2a, 1.2b, 1.2g, 1.2h) and the four supplementary scanning units (1.2c - 1.2f) are arranged on one side of the object (1).

2. Assembly according to Claim 1, **characterized in that** the maximum spacing ($DA_{y1}$) of the outer scanning units (1.2a, 1.2b, 1.2g, 1.2h) along the first main movement axis (y) respectively corresponds to the length ($DM_y$) of one of the scales (2.1, 2.2) along the first main movement axis (y).

3. Assembly according to Claim 2, **characterized in that** the spacing ($DA_{y2}$) of the inner supplementary scanning units (1.2c - 1.2f) along the first main movement axis (y) is smaller than the spacing ($DA_{y1}$) of the outer scanning units (1.2a, 1.2b, 1.2g, 1.2h) along the first main movement axis (y).

4. Assembly according to Claim 1, **characterized in that** the maximum spacing ($DA_x$) of the scanning units (1.2a, 1.2b, 1.2g, 1.2h) and also of the supplementary scanning units (1.2c - 1.2f) along the second main movement axis (x) corresponds to the length ($DM_x$) of the scales (2.1, 2.2) along the second main movement axis (x).

5. Assembly according to Claim 1, **characterized in that** along the first main movement axis (y), a maximum travel of

$$V = 2 \cdot DM_y - DA_{y2}$$

results,
where

   V:= maximum travel along the first main movement axis,
   $DM_y$:= length of the scales along the first main movement axis,
   $DA_{y2}$:= spacing of the supplementary scanning units along the first main movement axis,

   wherein, along this travel (V), continuous position detection is possible via the scanning units (1.2a, 1.2b, 1.2g, 1.2h) and the supplementary scanning units (1.2c - 1.2f).

6. Assembly according to at least one of the preceding claims, **characterized in that** the scanning units (1.2a, 1.2b, 1.2g, 1.2h) and also the supplementary scanning units (1.2c - 1.2f) each comprise a one-dimensional scanning grid (1.2cG - 1.2dG), and the scanning units (1.2a, 1.2b, 1.2g, 1.2h) and also the supplementary scanning units (1.2c - 1.2f) are arranged in such a way that the gridlines of the respectwely associated scanning grids (1.2cG - 1.2dG) are oriented so as to be rotated by +45° or by -45° with respect to the first main movement axis (y).

7. Assembly according to at least one of the preceding claims, **characterized in that** for the purpose of position detection, individual scanning units (1.2a, 1.2b, 1.2g, 1.2h; 11.2a, 11.2b, 11.2g, 11.2h) and/or supplementary scanning units (1.2c - 1.2f; 11.2c - 11.2f) are formed such that they can be activated optionally.

**Revendications**

1. Système comportant

   - un objet (1) qui est disposé de manière mobile au moins le long de deux axes orthogonaux, à savoir des premier et second axes de mouvement principaux (y, x) par rapport à un référentiel, et

- un dispositif de mesure de position destiné à détecter la position de l'objet (1 ; 11) par rapport au référentiel, comportant au moins deux mesures matérialisées (2.1, 2.2) bidimensionnelles disposées le long du premier axe de mouvement principal (y) et quatre unités de balayage (1.2a, 1.2b, 1.2g, 1.2h) destinées à effectuer un balayage optique des mesures matérialisées (2.1, 2.2),

**caractérisé**

- **en ce que** le dispositif de mesure de position comprend au moins quatre unités de balayage d'extension (1.2c - 1.2f) supplémentaires qui sont disposées le long du premier axe de mouvement principal (y) entre les quatre unités de balayage (1.2a, 1.2b, 1.2g, 1.2h), et
- **en ce que** les quatre unités de balayage (1.2a, 1.2b, 1.2g, 1.2h) et les quatre unités de balayage d'extension (1.2c - 1.2f) sont disposées d'un côté de l'objet (1).

2. Système selon la revendication 1, **caractérisé en ce que** la distance maximale ($DA_{y1}$) des unités de balayage extérieures (1.2a, 1.2b, 1.2g, 1.2h) le long du premier axe de mouvement principal (y) correspond respectivement à la longueur ($DM_y$) de l'une des mesures matérialisées (2.1, 2.2) le long du premier axe de mouvement principal (y).

3. Système selon la revendication 2, **caractérisé en ce que** la distance maximale ($DA_{y2}$) des unités de balayage d'extension intérieures (1.2c - 1.2f) le long du premier axe de mouvement principal (y) est inférieure à la distance ($DA_{y1}$) des unités de balayage extérieures (1.2a, 1.2b, 1.2g, 1.2h) le long du premier axe de mouvement principal (y).

4. Système selon la revendication 1, **caractérisé en ce que** la distance maximale ($DA_x$) des unités de balayage (1.2a, 1.2b, 1.2g, 1.2h) ainsi que des unité de balayage d'extension (1.2c - 1.2f) le long du second axe de mouvement principal (x) correspond à la longueur ($DM_x$) des mesures matérialisées (2.1, 2.2) le long du second axe de mouvement principal (x).

5. Système selon la revendication 1, **caractérisé en ce que**, le long du premier axe de mouvement principal (y), une course de déplacement maximale est obtenue sous la formé

$$V = 2 \cdot DM_y - DA_{y2},$$

V = course de déplacement maximale le long du premier axe de mouvement principal,
$DM_y$ = longueur des mesures matérialisées le long du premier axe de mouvement principal,
$DA_{y2}$ = distance des premières unités de balayage d'extension le long du premier axe de mouvement principal,

dans lequel, le long de ladite course de déplacement (V), une détection de position continue est possible par l'intermédiaire des unités de balayage (1.2a, 1.2b, 1.2g, 1.2h) et des unités de balayage d'extension (1.2c-1.2f).

6. Système selon au moins l'une des revendications précédentes, **caractérisé en ce que** les unités de balayage (1.2a, 1.2b, 1.2g, 1.2h) ainsi que les unités de balayage d'extension (1.2c-1.2f) comprennent respectivement un réseau de balayage unidimensionnel (1.2cG, 1.2dG) et les unités de balayage (1.2a, 1.2b, 1.2g, 1.2h) ainsi que les unités de balayage d'extension (1.2c-1.2f) sont disposées de manière à ce que les stries de réseau du réseau de balayage (1.2cG, 1.2dG) correspondant respectif soient orientées de manière tournée de +45° ou de -45° par rapport au premier axe de mouvement principal (y).

7. Système selon au moins l'une des revendications précédentes, **caractérisé en ce que** des unités de balayage individuelles (1.2a, 1.2b, 1.2g, 1.2h ; 11.2a ; 11.2b , 11.2g, 11.2h) et/ou des unités de balayage d'extension individuelles (1.2c-1.2f ; 11.2c-11.2f) sont réalisées de manière à ce qu'elles puissent être activées sélectivement pour la détection de position.

Fig. 1a

Fig. 1b

EP 2 626 672 B1

Fig. 2

Fig. 3a

Fig. 3b

Fig. 3c

Fig. 3d

Fig. 4

EP 2 626 672 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 7602489 B2

- EP 1762828 A2